# EUROPEAN PATENT APPLICATION

(11) **EP 2 587 172 A1**
(43) Date of publication of application: **01.05.2013**
(21) Application number: 12190527.7
(22) Date of filing: 30.10.2012
(51) Int. Cl.: F24F 1/00, F24F 13/20, F24F 13/32, F24F 1/38, H05K 7/20

(54) **Fan supporting structure for climate control machines with underfloor air flow**

(30) Priority: 31.10.2011 IT PD20110343
(71) Applicant: Emerson Network Power S.R.L., 35028 Piove di Sacco (PD) (IT)
(72) Inventor: De Zen, Daniele, 35020 Correzzola PD (IT)
(74) Representative: Modiano, Micaela Nadia

(57) **Abstract**

A fan supporting structure (10) for climate control machines with underfloor air flow; the climate control machines (11) comprise a cabinet (12) with air intake grilles (13), heat exchange means (14) inside, and fans (15) which are adapted to propel air into the space (16) under the floor (17); a fan (15) comprises an intake part (18), which is fixed proximate to the heat exchange means (14), and an impeller part (19), and is supported below the intake part (18).

The fan supporting structure (10) comprises a framework (22), with an upper plate (23) to which the intake part (18) is fixed, and has lower cross-members (24, 24a) which support a base (25) for engagement and disengagement with two configurations, the impeller (19) being arranged on the base (25).

## Description

The present invention relates to a fan supporting structure for climate control machines with underfloor air flow.

Server rooms, and in general any site that contains numerous electronic devices and racks for supporting a plurality of servers, electrical and electronic instruments and the like, generally enclosed within adapted ventilated cabinets, require continuous climate control that is adapted to prevent the heat originating from the computers and from the electronic instruments themselves from accumulating and thus determining temperatures that are so high as to damage the internal components of such electronic instruments and the like.

Nowadays, in order to overcome these drawbacks, floor climate control plants are generally installed in server rooms, and are increasingly widespread particularly in environments installed on a raised floor.

In fact the space between the ground and the raised floor can be easily fitted out not only for the distribution of cables for connecting and powering the racks and computers, but also as a plenum space, i.e. as an area for the passage of conditioned air, fed in by one or more cooling and climate control machines, such plenum spaces conveying the air, by way of floor grilles, either to the overlying environment or directly into the rack cabinets.

Machines for such climate control are generally constituted by a cabinet within which heat exchange means are arranged below which there are, generally arranged below the raised floor, a plurality of fans which are designed to aspirate air from the upper part of the cabinet so that it crosses the heat exchange means and is then pushed, treated, into the underfloor space.

Such a cooling and climate control system, although very widespread and appreciated, exhibits some drawbacks.

One such drawback is determined by the possible underfloor position of such fans, the removal of which, for repairs or ordinary maintenance, is very inconvenient.

In fact at present, in such machines, the fans comprise an intake part which is substantially frustum-shaped, known in the trade as a "nozzle", fixed to a framework proximate to one end of exchange means, and an impeller part, which is provided with vanes and is motorized, supported by the framework below the intake part, with a portion of the intake part inserted in the corresponding air intake of the impeller.

Nowadays the removal of such a fan requires the removal of the intake part, thus obtaining access to the fan in order to be able to remove or work on the latter.

Such sequence of operations requires a large amount of time and requires the operator to work over much of this time in positions that are very awkward and uncomfortable, since he has to work in the underfloor space, or just above it.

The aim of the present invention is to provide a fan supporting structure for climate control machines with underfloor air flow which makes it possible to overcome the above-mentioned drawbacks of the known art.

Within this aim, an object of the invention is to provide a fan supporting structure that enables the quick and easy removal and repositioning of the impeller part, which is provided with vanes and motorized.

Another object of the invention is to provide a fan supporting structure that frees the operator from the necessity of working for long periods in uncomfortable positions.

Another object of the invention is to provide a fan supporting structure which can be easily associated with conventional frames of climate control machines and the like.

Another object of the invention is to provide a fan supporting structure for climate control machines with underfloor air flow which can be produced using conventional systems and technologies.

This aim and these and other objects which will become more apparent hereinafter are all achieved by a fan supporting structure for climate control machines with underfloor air flow, said climate control machines comprising a cabinet with one or more air intake grilles, inside which there are heat exchange means below which there are one or more fans adapted to aspirate air from the overlying cabinet and propel it into the space under the floor, said fan comprising an intake part, which is fixed proximate to the exchange means, and an impeller part, which is provided with vanes and motorized, and is supported below said intake part, said intake part being inserted, with a portion thereof, in the corresponding air intake of said impeller, said fan supporting structure being **characterized in that** it comprises a substantially parallelepiped framework, with an upper plate to which said intake part is fixed, lower cross-members being provided which support a base for engagement and disengagement with two configurations, said impeller being arranged on said base, said base being provided with opposite lateral flaps for locking to said cross-members, each one of said flaps having a front hole for locking the base in a first configuration for stable fixing with the fan mounted and the intake part inserted in said impeller, and a rear slot which is contoured to allow the lowering and the translational motion of the base in order to assume a second, disassembly configuration, with the impeller lowered and extracted from said intake part.

Further characteristics and advantages of the invention will become more apparent from the description of a preferred, but not exclusive, embodiment of the fan supporting structure according to the invention, which is illustrated by way of non-limiting example in the accompanying drawings wherein:
Figure 1 is a schematic side view of a fan supporting structure according to the invention, associated with a climate control machine;
Figure 1a is a perspective view of the fan supporting structure according to the invention;
Figure 2 is a side view of a fan supporting structure according to the invention in a first configuration of use;
Figure 3 is a side view of a fan supporting structure in an intermediate configuration;
Figure 4 is a side view of a fan supporting structure according to the invention in a second configuration of use.

With reference to the figures, a fan supporting structure according to the invention is generally designated with the reference numeral 10.

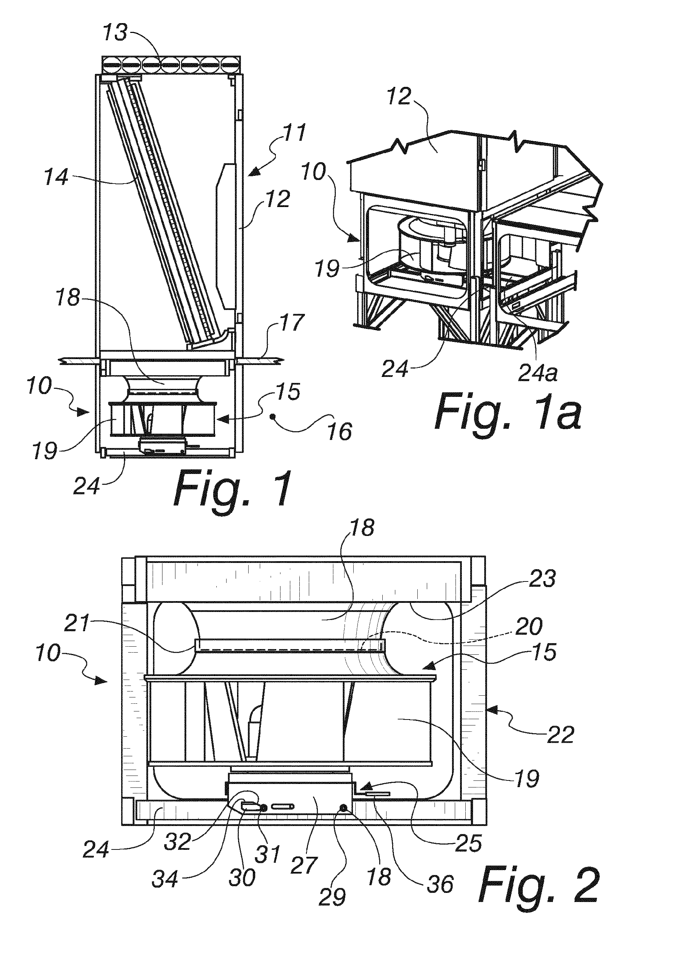

An example of a climate control machine for which such a fan supporting structure 10 is designed is shown in Figure 1, where it is generally designated with the reference numeral 11.

Such a climate control machine 11 comprises a cabinet 12 with one or more air intake grilles 13, inside which there are heat exchange means 14, which should be understood as being of a conventional type and is represented here by an exchanger with tubes and fins.

Below the heat exchange means 14 there are one or more fans, exemplified by a fan 15, which are adapted to draw air from the overlying cabinet 12 and to propel it into the space 16 under the floor 17.

Each fan 15 comprises an intake part 18, which is fixed proximate to the exchange means, and an impeller part 19, which is provided with vanes and motorized, and is supported below the intake part 18.

A portion 20 of the intake part 18 is inserted in the corresponding air intake 21 of the impeller 19.

The fan supporting structure 10 according to the invention comprises a framework 22, substantially parallelepiped, with an upper plate 23 to which the intake part 18 is fixed.

The intake part 18 is substantially frustum-shaped and extends downward from the plate 23.

The framework 22 has two lower parallel cross-members, of which only one, designated with 24, is visible in Figures 1 to 4, where it is understood that there is a second, identical and symmetric one arranged in parallel and partially visible in Figure 1a.

Such lower cross-members 24 and 24a support a base for engagement and disengagement 25 which is capable of assuming two configurations, described below.

Arranged on such base 25 is the impeller 19 with its motor drive 26, which should be understood as being of a conventional type.

The base 25 has two opposite and symmetrical lateral flaps, of which only one is visible in the figures and designated therein with 27, for locking the cross-members 24 and 24a.

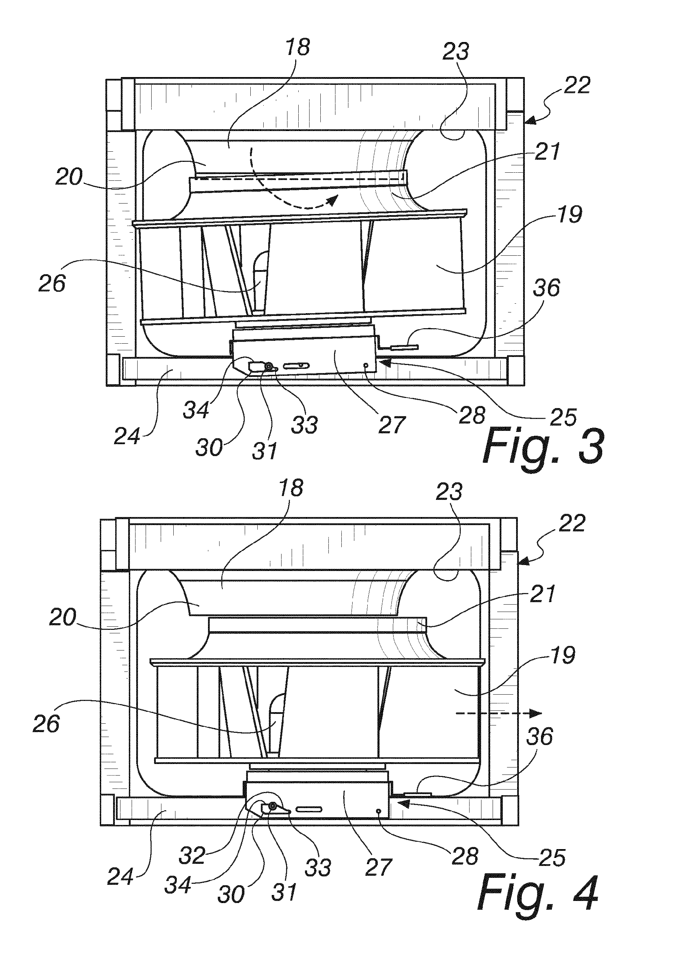

Such flaps 24, which can be made for example from sheet metal monolithically with the base 25, each have:
- a front hole 28 for locking, by way of a first screw 29, the base 25 in a first configuration for stable fixing with the impeller 19 mounted and the intake part 18 inserted in the impeller 19, as in Figure 2,
- and a rear slot 30, for a second screw 31, which is contoured to allow the lowering and translational motion of the base 25 in order to assume a second, disassembly configuration, with the impeller 19 lowered and extracted from the intake part 18, as in Figure 4.

Such rear slot 30 in fact has a rim 32 thereof inclined between two rim portions, 33 and 34, which are substantially horizontal.

The first horizontal portion 33 of the rim is the lower portion, and is also the stroke limiting portion for the second screw 31 within the rear slot 30, where the second screw 31 is screwed in order to lock the base 25 in the first, raised configuration for the coupling of the impeller 19 with the intake part 18, which is thus the configuration for operation of the fan 15.

The second horizontal portion 34 is the higher portion with respect to the inclined rim 32.

The base 25 also has an actuation handle 36 which facilitates the extraction of the base 25 by an operator, once the base 25 has been lowered so as to rest on the two cross-members 24 and 24a which also act as rails for its sliding during extraction and reinsertion.

The use of the fan supporting structure 10 according to the invention is as follows.

The fan 15 in the configuration for use is exemplified in Figure 2, with the first screw 29 and second screw 31 screwed and thus supporting the base 25.

For removal of the impeller 19 the first screws 29 are unscrewed and removed thus freeing the first holes 28, and at the same time the second screws 31 are loosened without being removed, thus making it possible for the base 25, pulled by the handle 36 and supported at the front by way of the same handle, to slide forward until the second screws 31 have exited the respective stroke limiting indentations, such sliding made possible by the play between the portion 20 of the intake part 18 and the air intake 21 of the impeller 19. Once the second screws 31 are positioned at the inclined rim 32 of the rear slots, the operator supports the base 25 at the front while allowing to the impeller a small rotation with lowering of the rear part of said impeller, such lowering and advancement occurring along the path defined by the upper inclined rims 32 of the rear slots 30, the inclined rims 32 sliding on the second screws 31.

The base 25 is lowered until it comes to rest on the cross-members 24 and 24a.

At that point, the operator grips the handle 36 and extracts the base 25 with the impeller 19, the latter having descended for a portion which is such as to ensure the disengagement of the intake part 18 from the air intake 21 of the impeller 19.

In practice it has been found that the invention fully achieves the intended aim and objects.

In particular with the invention a fan supporting structure is provided which enables the quick and easy removal and repositioning of the impeller part, which is provided with vanes and motorized.

Moreover, with the invention a fan supporting structure is provided which frees the operator from having to work for long periods in awkward positions, since for the removal and the reinsertion of the impeller part 19 it is necessary and sufficient to unscrew the screws 29 and 31 and move the base 25 by way of the convenient handle 36, without having to resort to lengthy and laborious operations of disassembly and reassembly of numerous components below the floor, or just above it, as in the known art.

What is more, with the invention a fan supporting structure is provided which can be easily associated with conventional frames of climate control machines and the like, since such a structure is a steel structure which can be easily produced so as to be adaptable to the most varied structural configurations of climate control machines.

In addition, with the invention a fan supporting structure has been devised for climate control machines with underfloor air flow, which can be produced using conventional systems and technologies.

The invention, thus conceived, is susceptible of numerous modifications and variations, all of which are within the scope of the appended claims. Moreover, all the details may be substituted by other, technically equivalent elements.

In practice the materials employed, and the contingent dimensions and shapes, may be any according to requirements and to the state of the art.

The disclosures in Italian Patent Application No. PD2011A000343 from which this application claims priority are incorporated herein by reference.

Where technical features mentioned in any claim are followed by reference signs, such reference signs have been inserted for the sole purpose of increasing the intelligibility of the claims and accordingly such reference signs do not have any limiting effect on the interpretation of each element identified by way of example by such reference signs.

## Claims

1. A fan supporting structure (10) for climate control machines with underfloor air flow, said climate control machines (11) comprising a cabinet (12) with one or more air intake grilles (13), inside which there are heat exchange means (14) below which there are one or more fans (15) adapted to aspirate air from the overlying cabinet and propel it into the space (16) under the floor (17), said fan (15) comprising an intake part (18), which is fixed proximate to the heat exchange means (14), and an impeller part (19), which is provided with vanes and motorized, and is supported below said intake part (18), said intake part (18) being inserted, with a portion (20) thereof, in the corresponding air intake (21) of said impeller (19), said fan supporting structure (10) being **characterized in that** it comprises a framework (22), with an upper plate (23) to which said intake part (18) is fixed, lower cross-members (24, 24a) being provided which support a base (25) for engagement and disengagement with two configurations, said impeller (19) being arranged on said base (25), said base (25) being provided with opposite lateral flaps (27) for locking to said cross-members (24, 24a), each one of said flaps having a front hole (28) for locking the base (25) in a first configuration for stable fixing with the fan (15) mounted and the intake part (18) inserted in said impeller (19), and a rear slot (30) which is contoured to allow the lowering and the translational motion of the base (25) in order to assume a second, disassembly configuration, with the impeller (19) lowered and extracted from said intake part (18).

2. The fan supporting structure according to claim 1, **characterized in that** said rear slot (30) is provided with a rim (32) which is inclined between two substantially horizontal rim portions (33, 34).

3. The fan supporting structure according to one or more of the preceding claims, **characterized in that** a first horizontal portion (33) of the rim of said rear slot (30) is the lowest portion of the upper edge of said rear slot (30) and is the stroke limiting portion for a screw (31) within the rear slot (30), at which said screw (31) is screwed in order to lock the base (25) in the first, raised configuration for the coupling of the impeller (19) with the intake part (18), the other horizontal portion (34) being the portion that is higher than the inclined rim (32).

4. The fan supporting structure according to one or more of the preceding claims, **characterized in that** said base (25) is provided with an actuation handle (36) which facilitates the extraction of the base (25) by an operator once said base (25) has been lowered so as to rest on the two cross-members (24, 24a).
